# EUROPÄISCHE PATENTSCHRIFT

(11) **EP 4 013 716 B1**
(45) Veröffentlichungstag und Bekanntmachung des Hinweises auf die Patenterteilung: **19.11.2025**
(21) Anmeldenummer: 20757866.7
(22) Anmeldetag: 13.08.2020
(51) Int. Cl.: B81C 1/00, B23K 26/53

(54) **VERFAHREN ZUM BEARBEITEN EINES WERKSTÜCKS**
METHOD FOR MACHINING A WORKPIECE
PROCÉDÉ POUR USINER UNE PIÈCE

(30) Priorität: 13.08.2019 DE 102019121827
(43) Veröffentlichungstag der Anmeldung: 22.06.2022
(73) Patentinhaber: TRUMPF Laser- und Systemtechnik SE, 71254 Ditzingen (DE)
(72) Erfinder: KUMKAR, Malte, 99425 Weimar (DE); KAISER, Myriam, 71254 Ditzingen (DE)
(74) Vertreter: Trumpf Patentabteilung
(86) Internationale Anmeldenummer: PCT/EP2020/072754
(87) Internationale Veröffentlichungsnummer: WO 2021/028534

(56) Entgegenhaltungen:
- US-A1- 2018 029 924

## Beschreibung

### Technisches Gebiet

Die vorliegende Erfindung betrifft ein Verfahren zum Bearbeiten eines Werkstücks, insbesondere zum Einbringen zumindest einer Ausnehmung oder Durchbrechung in das Werkstück, mittels Laserätzen.

### Stand der Technik

Beim Laserätzen wird ein für die verwendete Laserstrahlung transparentes Material mittels eines oder mehrerer ultrakurzer Laserpulse, in deren Fokus nichtlinear induzierte Absorptionsvorgänge, beispielsweise Multiphotonenabsorptionen oder Tunnelionisation stattfinden, modifiziert. Dabei werden die chemischen und/oder physikalischen Eigenschaften des Materials so modifiziert, dass das Material besser ätzbar wird. In einem nachfolgenden Schritt wird dann mit einem Ätzverfahren das modifizierte Material selektiv entfernt.

Unter einer Selektivität des Ätzvorgangs wird dabei das Verhältnis zwischen der Ätzrate bei modifiziertem Material und der Ätzrate bei unmodifiziertem Material verstanden.

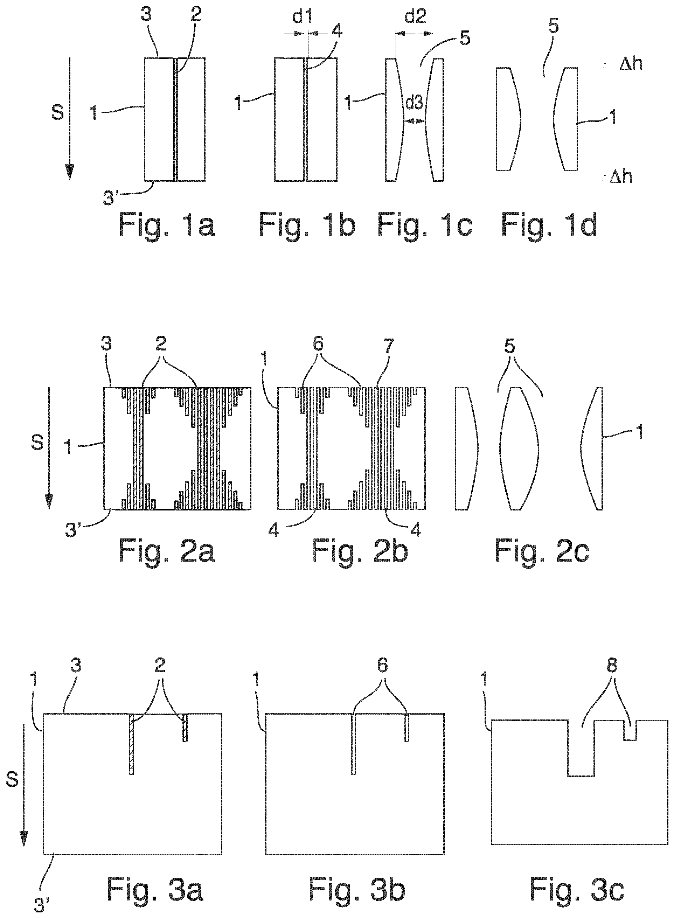

Wenn während des Ätzvorgangs auch das unmodifizierte Material (allerdings langsamer) entfernt wird, ist es nicht möglich, in einem Verfahren präzise Konturen unterschiedlicher Größe in einem Werkstück allein und direkt durch die Geometrie der eingebrachten Modifikationen zu erzeugen. Mit einer langgezogenen, durchgängigen Modifikation über die gesamte Materialstärke wie in Fig. 1a gezeigt können je nach Ätzangriff unterschiedliche Hohlräume in transparenten Materialien erzeugt werden. In einem selektiven Ätzschritt mit hoher Selektivität beispielsweise wird überwiegend nur das modifizierte Material angegriffen wohingegen das unmodifizierte Material weitestgehend resistent ist. Auf diese Weise können beispielsweise Durchgangslöcher mit gleichbleibendem Durchmesser über die gesamte Materialstärke in transparentem Material erzeugt werden (siehe Fig. 1b). Wird anstelle eines Ätzschritts mit hoher Selektivität ein Ätzschritt mit geringer Selektivität im Anschluss an das Modifizieren durchgeführt, kann sowohl modifiziertes als auch (in geringerem Maße) nicht modifiziertes Material geätzt werden. Aus langgezogenen Lasermodifikationen können auf diese Weise sanduhrförmige Durchgangslöcher erzeugt werden (siehe Fig. 1c). Das Verhältnis der Durchmesser von Eingang/Austritt zu Taille kann mit diesem Verfahren über die Ätzzeit eingestellt werden. Bei hohen Ätzzeiten kann es allerdings in einem weniger selektiven Ätzschritt zu einer Reduktion der Materialstärke Δh kommen. Außerdem ist der minimale oberflächennahe Durchmesser der Durchgangslöcher, über den der Ätzzugang erfolgt, demnach von der Materialstärke abhängig.

In der WO 2018/162385 A1 wird ein Verfahren zum Laserätzen beschrieben, bei dem durch die Veränderung der Laserparameter unterschiedliche Modifikationen in das transparente Material eingebracht werden. Dadurch kann im nachfolgenden Ätzschritt eine unterschiedliche Selektivität je nach Art der Modifikation erreicht werden.

Dokument US 2018/029924 A1 offenbart ein Verfahren das durch kombiniertes Ätzen und die Bildung eines veränderten Teils des Substrats mittels UV-Laserbestrahlung, es ermöglicht, ein Loch mit einem kreisförmigen Umriss und einer glatten Innenwand herzustellen.

### Darstellung der Erfindung

Ausgehend von dem bekannten Stand der Technik ist es eine Aufgabe der vorliegenden Erfindung, ein verbessertes Verfahren zum Bearbeiten von Werkstücken mittels Laserätzen bereitzustellen. Die Aufgabe wird durch ein Verfahren mit den Merkmalen des Anspruchs 1 gelöst. Vorteilhafte Weiterbildungen ergeben sich aus den Unteransprüchen, der Beschreibung und den Figuren.

Entsprechend wird ein Verfahren zum Bearbeiten eines Werkstücks vorgeschlagen, umfassend die Schritte des Einbringens einer Mehrzahl benachbarter Modifikationen in das Material des Werkstücks mittels Laserstrahlung, dann des Ätzens des Materials des Werkstücks in einem ersten Ätzvorgang mit einer ersten Selektivität, um überwiegend das durch die Laserstrahlung modifizierte Material zu entfernen, und dann, nach Abschluss des ersten Ätzvorgangs, des Ätzens des Materials des Werkstücks (1) in einem zweiten Ätzvorgang mit einer zweiten, zu der ersten Selektivität unterschiedlichen Selektivität, um die zwischen dem entfernten modifizierten Material übrig gebliebenen Stege zu entfernen.

Die Modifikation kann ein geändertes Verhalten des modifizierten Materials gegenüber einem Ätzmittel bewirken. Damit die Modifikation nicht nur an der Oberfläche, sondern auch in tieferen Lagen des Werkstücks eingebracht werden kann, ist das Material des Werkstücks vorzugsweise transparent zumindest für die Wellenlänge der verwendeten Laserstrahlung. Um Verluste beim Eintritt der Laserstrahlung in das Material zu vermeiden oder verringern, sollte die Oberfläche möglichst glatt und frei von Verunreinigungen sein. Das Material kann beispielsweise Glas, transparente Keramik, Glaskeramik oder Saphir sein.

Die Modifizierung des Materials des Werkstücks kann insbesondere mittels eines Laserstrahls in Form eines Bessel-Strahls, insbesondere eines Quasi-Bessel-Strahls (im Folgenden auch einfach nur Bessel-Strahl genannt) mit einer langgezogenen Fokuszone erfolgen. Diese langgezogene Fokuszone hat ein über die Bearbeitungslänge (z.B. über die Dicke des Werkstücks) hinweg ein im Wesentlichen gleichbleibendes Strahlprofil. In der Praxis können bereits langgezogene Fokuszonen mit einer Länge von mehr als 10 mm erzeugt werden. Die Erzeugung solcher Quasi-Bessel-Strahlen wird beispielsweise in der DE 10 2014 116 958 B4 und in der WO 2016/079062 A1 beschrieben.

Die Modifizierung des Materials des Werkstücks kann auch mittels eines Laserstrahls in Form eines fokussierten Gauß-Strahls erfolgen, wobei hier die Modifizierung des Materials im Wesentlichen im Fokus des Laserstrahls erfolgt.

Die Laserquelle kann in Bezug auf das Werkstück beweglich, insbesondere zumindest in zwei Raumrichtungen senkrecht zur Ausbreitungsrichtung des Laserstrahls, aber auch in allen Raumrichtungen verschiebbar, angeordnet sein. Bei einer Verschiebbarkeit in drei Raumrichtungen kann der Fokus des Laserstrahls in gewünschter Weise parallel und senkrecht zur Oberfläche des Werkstücks bewegt werden.

Mehrere nacheinander eingebrachte Modifikationen können voneinander getrennt in das Material des Werkstücks eingebracht werden, sodass sie sich nicht überlappen. Dies verringert die Belastung des Werkstücks und reduziert die Gefahr von Rissen oder anderen Beschädigungen innerhalb des Werkstücks. Alternativ können nacheinander eingebrachte Modifikationen sich überlappen und somit eine zusammenhängende Modifikation ergeben. Solche überlappenden Modifikationen werden hier und im Folgenden als eine Modifikation betrachtet. Auch eine Kombination von überlappenden und nicht überlappenden Modifikationen ist möglich.

Eine Modifikation kann sich beispielsweise von der Arbeitsoberfläche des Werkstücks (d.h. von der Oberfläche, durch die der Laserstrahl in das Werkstück eintritt) bis in eine definierte Tiefe (von der Arbeitsoberfläche aus betrachtet) des Werkstücks erstrecken, insbesondere linear und entlang der Ausbreitungsrichtung des Laserstrahls. Hierzu kann beispielsweise ein Bessel-Strahl mit einer Fokuszone, die kürzer ist als die Materialstärke, verwendet werden, oder ein Bessel-Strahl mit einer längeren Fokuszone kann so positioniert werden, dass die Modifikation nicht über die gesamte Materialstärke erfolgt. Mittels eines Bessel-Strahls mit einer Fokuszone, die kürzer ist als die Materialstärke können auch Modifikationen im Inneren des Werkstücks eingebracht werden, die keine direkte Verbindung zu einer Oberfläche des Werkstücks aufweisen. Eine Modifikation kann sich auch über die gesamte Dicke des Werkstücks, d.h. von der Arbeitsoberfläche bis zur gegenüberliegenden Oberfläche des Werkstücks erstrecken.

Nach dem Einbringen der mindestens einen Modifikation wird das Werkstück einem Ätzvorgang mit variierender Selektivität unterzogen. Unter der Selektivität des Ätzvorgangs wird dabei das Verhältnis zwischen der Ätzrate bei modifiziertem Material und der Ätzrate bei unmodifiziertem Material verstanden. Die Selektivität des Ätzvorgangs kann insbesondere durch die chemische Zusammensetzung, die Temperatur und/oder die Konzentration des Ätzmittels eingestellt werden.

Der Ätzvorgang kann ein Flüssigätzvorgang, ein Trockenätzvorgang oder ein Dampfphasenätzvorgang sein. Als Ätzmittel bei einem Flüssigätzvorgang kann beispielsweise eine wässrige Lösung von KOH verwendet werden. Beispielsweise kann der Ätzvorgang ein Flüssigätzvorgang sein, der in einem Ultraschallbad durchgeführt wird. Dann kann die Selektivität des Ätzvorgangs auch über die eingebrachte Ultraschallleistung eingestellt werden.

Um die Selektivität des Ätzvorgangs zu variieren kann während des Ätzvorgangs einer oder mehrere der für die Selektivität bestimmenden Parameter geändert werden. Beispielsweise kann die Temperatur erhöht oder verringert werden. Dadurch verändert sich die Selektivität während des Ätzvorgangs.

Je nach Selektivität des Ätzvorgangs bzw. des jeweiligen Abschnitts des Ätzvorgangs wird dann überwiegend oder nahezu ausschließlich das modifizierte Material und nur zum geringeren Teil oder kaum das unmodifizierte Material entfernt.

Es ist auch vorgesehen, dass der Ätzvorgang mit variierender Selektivität zwei oder mehr Ätzvorgänge mit jeweils fester Selektivität umfasst. Beispielsweise kann das Werkstück zunächst einem ersten Ätzvorgang mit einer ersten Selektivität und - nach Abschluss des ersten Ätzvorgangs - einem zweiten Ätzvorgang mit einer zweiten Selektivität unterzogen werden. Dabei kann insbesondere bei beiden Ätzvorgängen ein anderes Ätzmittel zum Einsatz kommen.

Dabei wird das modifizierte Material des Werkstücks in dem ersten Ätzvorgang entfernt. Der erste Ätzvorgang hat eine erste Selektivität, d.h. das Verhältnis zwischen der Ätzrate bei modifiziertem Material und der Ätzrate bei unmodifiziertem Material hat einen ersten Wert. Das modifizierte Material wird dabei schneller geätzt als das unmodifizierte Material, sodass das Material des Werkstücks überwiegend entlang der Modifikation entfernt wird.

Während des ersten Ätzvorgangs wird das Werkstück für eine erste Zeit z.B. in ein Bad einer ersten Ätzlösung mit einer ersten Konzentration und einer ersten Temperatur gegeben. Vorzugsweise ist das Bad ein Ultraschallbad, d.h. es wird eine erste Ultraschallleistung in das Bad eingebracht.

Nach Abschluss des ersten Ätzvorgangs wird das Werkstück einem zweiten Ätzvorgang unterzogen. Dabei wird das Material des Werkstücks in dem zweiten Ätzvorgang entfernt. Der zweite Ätzvorgang hat eine zweite Selektivität, d.h. das Verhältnis zwischen der Ätzrate bei modifiziertem Material und der Ätzrate bei unmodifiziertem Material hat einen zweiten Wert.

Entsprechend kann durch das Ätzen des Materials in einem ersten Ätzvorgang mit hoher Selektivität überwiegend das durch die Laserstrahlung modifizierte Material entfernt werden. Durch das Ätzen des Materials in einem zweiten Ätzvorgang mit niedrigerer Selektivität können dann die zwischen dem entfernten modifizierten Material übrig gebliebenen Stege aus unmodifiziertem Material entfernt werden. Durch die während des ersten Ätzvorgangs gebildeten Kanäle wird ein Zugang für die zweite Ätzlösung geschaffen und die zweite Ätzlösung kann die Stege über deren gesamte Länge angreifen. Somit können die Stege rasch entfernt werden und die Auswirkung des zweiten Ätzvorgangs auf den Rest des Werkstücks lässt sich minimieren. Hiermit lassen sich insbesondere Ausnehmungen jeglicher gewünschter Form in das Werkstück einbringen.

Die erste Selektivität und die zweite Selektivität sind unterschiedlich groß. Auch hier wird das modifizierte Material schneller geätzt als das unmodifizierte Material, sodass das Material des Werkstücks überwiegend entlang der Modifikation entfernt wird, allerdings ist im zweiten Ätzvorgang das Verhältnis der Ätzraten unterschiedlich zum Verhältnis im ersten Ätzvorgang.

Während des zweiten Ätzvorgangs wird das Werkstück für eine zweite Zeit z.B. in ein Bad einer zweiten Ätzlösung mit einer zweiten Konzentration und einer zweiten Temperatur gegeben. Vorzugsweise ist das Bad ein Ultraschallbad, d.h. es wird eine zweite Ultraschallleistung in das Bad eingebracht. Das Werkstück kann für den zweiten Ätzvorgang auch im ersten Bad belassen werden und es werden die Selektivität bestimmende Parameter des Bades verändert, z.B. die Temperatur und/oder die Ultraschallleistung erhöht oder verringert.

Der erste Ätzvorgang und der zweite Ätzvorgang können sich durch die chemische Zusammensetzung, die Temperatur und/oder die Konzentration der Ätzlösungen und/oder durch die in einem Ultraschallbad eingebrachte Ultraschallleistung unterscheiden. Durch diese Parameter können die Selektivitäten der beiden Ätzvorgänge eingestellt werden.

Insbesondere können sich die erste Selektivität und die zweite Selektivität um mindestens den Faktor 2, vorzugsweise um den Faktor 100, weiter vorzugsweise um den Faktor 10000 unterscheiden.

In manchen Ausführungsformen des Verfahrens ist die erste Selektivität größer als die zweite Selektivität. Dies bedeutet, dass während des ersten Ätzvorgangs das modifizierte Material im Verhältnis zum unmodifizierten Material schneller abgetragen wird als während des zweiten Ätzvorgangs.

Dadurch wird es beispielsweise möglich, während des ersten Ätzvorgangs im Wesentlichen nur das modifizierte Material zu entfernen (hohe Selektivität, beispielsweise eine Selektivität von mindestens 1000). Somit kann ein Kanal entstehen, in den die zweite Ätzlösung während des zweiten Ätzvorgangs eindringen kann und entlang dessen die zweite Ätzlösung dann auch das nicht modifizierte Material entfernen kann (niedrigere Selektivität, beispielsweise eine Selektivität von höchstens 100). Die zweite Ätzlösung kann dann schon von Beginn des zweiten Ätzvorgangs an im Inneren des Kanals wirken und den Kanal schneller auf den gewünschten Durchmesser erweitern, sodass die Änderung in der Dicke des Werkstücks minimiert werden kann.

In einer weiteren Ausführungsform umfasst das Einbringen zumindest einer Modifikation das Einbringen einer Mehrzahl benachbarter Modifikationen in das Material mittels Laserstrahlung. Die Modifikationen können beispielsweise linear, entlang einer Kontur oder in einer zwei- oder dreidimensionalen Anordnung (regelmäßig in Form eines Gitters oder unregelmäßig) eingebracht werden. Als benachbart werden Modifikationen insbesondere dann angesehen, wenn der Abstand zwischen Ihnen nicht mehr als der fünffache, vorzugsweise der einfache Durchmesser der jeweiligen Modifikationen beträgt.

Die Mehrzahl von Modifikationen kann insbesondere innerhalb einer gewünschten Fläche für eine Ausnehmung im Werkstück angeordnet sein, beispielsweise innerhalb eines Kreises oder eines Polygons, oder innerhalb einer anderen, auch unregelmäßigen, Fläche.

Alle Modifikationen der Mehrzahl von Modifikationen können dieselbe Länge aufweisen. Zumindest einige der Modifikationen können auch unterschiedliche Längen aufweisen. Alle oder zumindest einige der Modifikationen können die gleiche Ausrichtung haben, d.h. zueinander parallel sein. Alle oder zumindest einige der Modifikationen können einen Ausgangspunkt in einer gemeinsamen Ebene haben, beispielsweise können sich alle oder zumindest einige der Modifikationen von der Arbeitsoberfläche in das Werkstück hinein erstrecken.

Wenn die Modifikationen innerhalb einer Fläche angeordnet sind, kann durch eine entsprechende Auswahl der Längen der Modifikationen der Winkel der Seitenwand einer Ausnehmung gestaltet werden. Beispielsweise können eine oder mehrere Modifikationen mit der größten Länge in der Mitte der Ausnehmung angeordnet sein und die Länge der Modifikationen kann zum Rand der Ausnehmung hin abnehmen.

Die Längen der in das Material des Werkstücks eingebrachten Modifikationen sind bevorzugt in der Propagationsrichtung des verwendeten Laserstrahls unterschiedlich.

In einer weiteren Ausführungsform wird eine Mehrzahl von Modifikationen entlang einer Kontur aneinander gereiht in das Material eingebracht wird. Unter einer Kontur wird hier ein vorgegebener Pfad verstanden, der beispielsweise dem Umfang einer geometrischen Figur (z.B. Kreis, Ellipse, Polygon, etc.) entspricht, aber auch unregelmäßig geformt sein kann. Solange der Pfad sich nicht selbst kreuzt oder zumindest nahekommt, werden die meisten der Modifikationen nur jeweils zwei benachbarte Modifikationen haben. Auch wenn bei einer gitterförmigen Anordnung über eine Fläche die Modifikationen eine nach der anderen und somit auch entlang eines Pfades in das Material eingebracht werden, wird eine solche Anordnung hier nicht als "entlang einer Kontur" betrachtet.

In einer weiteren Ausführungsform ist die Kontur, entlang der die Modifikationen in das Material eingebracht werden, geschlossen, d.h. sie umgibt eine Fläche vollständig (wobei selbstverständlich zwischen jeweils zwei benachbarten Modifikationen ein Abstand besteht). Eine solche Kontur kann insbesondere dem Umfang einer geometrischen Figur (z.B. Kreis, Ellipse, Polygon, etc.) entsprechen. Alle Modifikationen entlang dieser Kontur erstrecken sich über die Dicke des Werkstücks, d.h. von der Arbeitsoberfläche bis zur gegenüberliegenden Oberfläche des Werkstücks. Das Ätzen des Materials in einem ersten Ätzvorgang mit hoher Selektivität entfernt überwiegend das durch die Laserstrahlung modifizierte Material, sodass der von der Kontur umgebene Bereich und der Bereich außerhalb der Kontur noch über Stege aus unmodifiziertem Material verbunden sind. Das Ätzen des Materials in einem zweiten Ätzvorgang entfernt dann die zwischen dem entfernten modifizierten Material übrig gebliebenen Stege, sodass der von der Kontur umschlossene Bereich des Materials vom Bereich außerhalb getrennt wird und entfernt werden kann.

In manchen Ausführungsformen des Verfahrens ist die erste Selektivität kleiner als die zweite Selektivität. Dies bedeutet, dass während des ersten Ätzvorgangs das modifizierte Material im Verhältnis zum unmodifizierten Material langsamer abgetragen wird als während des zweiten Ätzvorgangs.

In einer Ausführungsform, in der die erste Selektivität kleiner ist als die zweite Selektivität, werden durch den zweiten Ätzvorgang mit hoher Selektivität zwei Teile des Werkstücks voneinander getrennt. Dies kann insbesondere dadurch erfolgen, dass in das Material des Werkstücks eine Reihe von benachbarten Modifikationen, die sich alle über die Dicke des Werkstücks, d.h. von der Arbeitsoberfläche bis zur gegenüberliegenden Oberfläche des Werkstücks erstrecken, eingebracht werden und das modifizierte Material durch den zweiten Ätzprozess mit hoher Selektivität entfernt wird. Benachbarte Modifikationen können sich überlappen oder können voneinander getrennt sein. Bei ausreichend geringem Abstand zwischen nicht-überlappenden Modifikationen (z.B. kleiner als der fünffache Durchmesser der Modifikation) lassen sich die beiden Teile des Werkstücks nach dem zweiten Ätzvorgang mechanisch voneinander trennen, z.B. durch Auseinanderziehen. Je nach Prozessparametern können sich die beiden Teile auch schon während des zweiten Ätzvorgangs von alleine voneinander trennen, da bedingt durch die Modifikationen in unmodifizierten Bereichen zwischen den Modifikationen Mikrorisse auftreten und sich ausbreiten können.

Im zuvor stattfindenden ersten Ätzprozess mit niedriger Selektivität wird entlang der Reihe von Modifikationen sowohl das modifizierte Material als auch (je nach Höhe der niedrigeren Selektivität ggf. mit geringerer Rate) das unmodifizierte Material abgetragen, wodurch eine Rundung auf beiden Seiten der Reihe von Modifikationen entstehen kann. Diese Rundungen ergeben nach dem oben beschriebenen Trennen der beiden Teile des Werkstücks jeweils eine abgerundete Kante (auch Fase oder Chamfer genannt) der beiden Teile.

Ein weiterer dritter Ätzvorgang mit geringer Selektivität oder gar mit Selektivität 1 (d.h. modifiziertes und unmodifiziertes Material werden gleich schnell geätzt, also keine Selektivität) kann vorgenommen werden, um insbesondere die Trennflächen zu glätten.

In weiteren Ausführungsformen des Verfahrens können nach Abschluss des Ätzens des Materials im zweiten Ätzvorgang ein oder mehrere weitere Ätzvorgänge mit jeweils unterschiedlicher Selektivität erfolgen, d.h. die Selektivität eines jeden weiteren Ätzvorgangs kann sich von der Selektivität des vorangegangenen Ätzvorgangs unterscheiden. Die Selektivitäten der weiteren Ätzvorgänge können den Selektivitäten der ersten beiden Ätzvorgänge entsprechen oder von diesen verschieden sein. Beispielsweise können nach Abschluss des Ätzens des Materials im zweiten Ätzvorgang, ein oder mehrere weitere Ätzvorgänge abwechselnd mit erster und zweiter Selektivität erfolgen. Somit kann insbesondere dann, wenn keine durchgehende Modifikation des Materials über die Dicke des Werkstücks möglich ist, in den Ätzvorgängen mit hoher Selektivität im Wesentlichen das modifizierte Material entfernt werden und in den Ätzvorgängen mit niedriger Selektivität auch das unmodifizierte Material entfernt werden, wodurch wiederum ein Zugang zu weiteren, zuvor nicht für die Ätzlösung erreichbaren Bereichen mit modifiziertem Material geschaffen werden kann. Diese weiteren Bereiche mit modifiziertem Material können dann wieder mittels eines Ätzvorgangs mit hoher Selektivität entfernt werden, ohne dass währenddessen in nennenswertem Umfang auch das unmodifizierte Material entfernt wird.

Mit Hilfe von Multispot-Modifikationen, d.h. Modifikationen mit mehreren modifizierten Bereichen in longitudinaler wie auch in transversaler Richtung, können beim Einsatz von Ätzlösungen unterschiedlicher Selektivität auch komplexe Strukturen (beispielsweise Linsen) in transparente Materialien eingebracht werden.

Bevorzugt ist das Material des Werkstücks für die Wellenlänge der Laserstrahlung transparent.

Bevorzugt werden die Modifikationen durch ultrakurze Laserpulse in das Material des Werkstücks eingebracht.

Das vorgeschlagene Verfahren hat gegenüber anderen Verfahren zur Materialbearbeitung (wie beispielsweise Laserbohren) den Vorteil, dass keine oder nur geringe Spannungen in das Material eingebracht werden, die bei Belastung oder im Laufe der Zeit zu Rissen im Material führen können. Dies gilt insbesondere dann, wenn benachbarte Modifikationen sich nicht überlappen, sodass zwischen ihnen ein unmodifizierter Bereich verbleibt.

Ferner wird vorliegend ein Werkstück mit einer Mehrzahl von langgezogenen Löchern offenbart, die mit einem erfindungsgemäßen Verfahren erzeugt wurden. Ein solches Werkstück kann insbesondere ein Sieb aus Glas, transparenter Keramik, Glaskeramik oder Saphir mit einer Mehrzahl von Durchgangslöchern von einer Oberfläche zu einer gegenüberliegenden Oberfläche sein. Vorzugsweise haben die Durchgangslöcher über ihre Länge einen im Wesentlichen konstanten Durchmesser. In einer Ausführungsform haben die Durchgangslöcher einen Durchmesser von weniger als 1 µm, beispielsweise etwa 500 nm ("Nanosieb").

### Kurze Beschreibung der Figuren

Bevorzugte weitere Ausführungsformen der Erfindung werden durch die nachfolgende Beschreibung der Figuren näher erläutert. Dabei zeigen:
- Figur 1: eine schematische Darstellung eines bekannten Verfahrens zum Laserätzen;
- Figur 2: eine schematische Darstellung einer ersten Ausführungsform eines erfindungsgemäßen Verfahrens zum Laserätzen;
- Figur 3: eine schematische Darstellung einer zweiten Ausführungsform eines erfindungsgemäßen Verfahrens zum Laserätzen;
- Figur 4: eine schematische Darstellung einer dritten Ausführungsform eines erfindungsgemäßen Verfahrens zum Laserätzen;
- Figur 5: eine schematische Darstellung einer vierten Ausführungsform eines erfindungsgemäßen Verfahrens zum Laserätzen;
- Figur 6: eine schematische Darstellung einer fünften Ausführungsform eines erfindungsgemäßen Verfahrens zum Laserätzen;
- Figur 7: eine schematische Darstellung eines Werkstücks, das mit einem erfindungsgemäßen Verfahren hergestellt wurde;
- Figur 8: eine schematische Darstellung einer sechsten Ausführungsform eines erfindungsgemäßen Verfahrens zum Laserätzen;
- Figur 9: eine schematische Darstellung einer siebten Ausführungsform eines erfindungsgemäßen Verfahrens zum Laserätzen;
- Figur 10: eine schematische Darstellung einer achten Ausführungsform eines erfindungsgemäßen Verfahrens zum Laserätzen;
- Figur 11: eine schematische Darstellung einer neunten Ausführungsform eines erfindungsgemäßen Verfahrens zum Laserätzen; und
- Figur 12: eine schematische Darstellung einer Laserbearbeitungsvorrichtung zum Modifizieren des Materials eines Werkstücks.

### Detaillierte Beschreibung bevorzugter Ausführungsbeispiele

Im Folgenden werden bevorzugte Ausführungsbeispiele anhand der Figuren beschrieben. Dabei werden gleiche, ähnliche oder gleichwirkende Elemente in den unterschiedlichen Figuren mit identischen Bezugszeichen versehen, und auf eine wiederholte Beschreibung dieser Elemente wird teilweise verzichtet, um Redundanzen zu vermeiden.

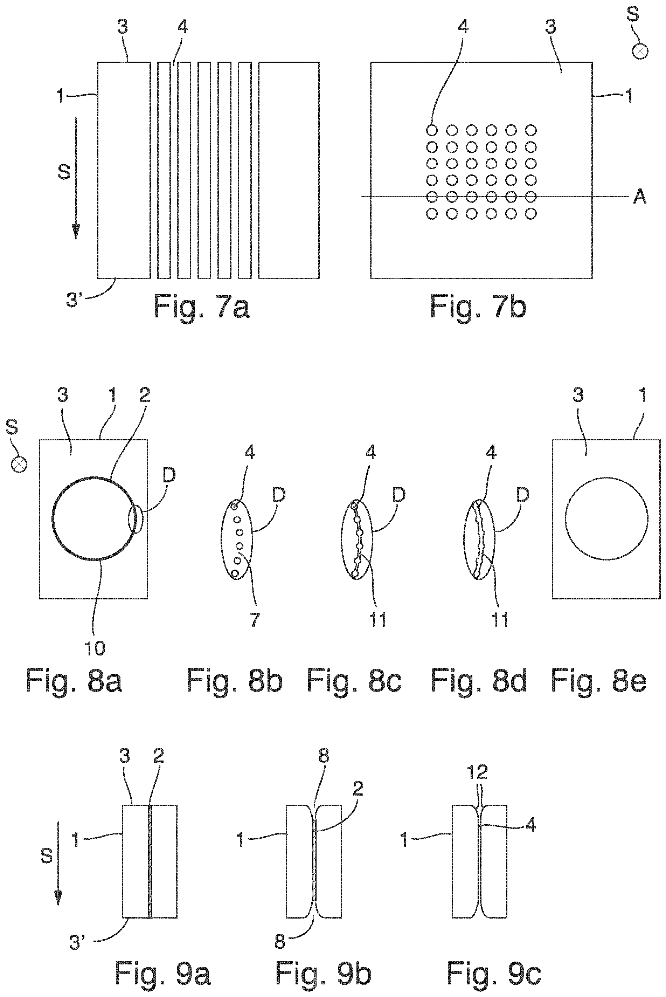

In den Figuren 1-6, 7a, sowie 9-11 ist jeweils ein Schnitt durch ein Werkstück 1 entlang der Strahlausbreitungsrichtung S eines für das Einbringen der Modifikationen 2 verwendeten Laserstrahls dargestellt. Die Figuren 7b und 8 zeigen eine Aufsicht auf das jeweilige Werkstück 1.

In Figur 1 ist schematisch ein bekanntes Verfahren zum Laserätzen dargestellt. Fig. 1a zeigt einen Ausschnitt aus einem Werkstück 1 mit einer Dicke h. In das Material des Werkstücks 1 wurde mittels Laserstrahlung, für die das Material des Werkstücks 1 transparent ist, eine langgezogene, durchgängige Modifikation 2 eingebracht, die sich von einer Oberfläche 3 zu einer anderen, gegenüberliegenden Oberfläche 3' erstreckt. In Fig. 1b ist das Werkstück 1 dargestellt, nachdem in einem selektiven Ätzschritt mit hoher Selektivität das modifizierte Material von der Ätzlösung angegriffen und entfernt wurde. Durch die hohe Selektivität des Ätzschritts wurde das unmodifizierte Material nicht oder nur unwesentlich angegriffen. Dadurch ist im Werkstück 1 ein Durchgangsloch 4 mit im Wesentlichen gleichbleibendem Durchmesser d1 entstanden.

In Fig. 1c ist das Werkstück 1 dargestellt, nachdem in einem Ätzschritt mit niedriger Selektivität anstelle des Ätzschritts mit hoher Selektivität sowohl das modifizierte Material als auch in geringerem Maße das unmodifizierte Material von der Ätzlösung angegriffen und entfernt wurde. Da über die Zeit, die der Ätzvorgang dauert, bis das modifizierte Material durchgehend entfernt wurde, das unmodifizierte Material nahe den Oberflächen 3, 3' länger der Ätzlösung ausgesetzt ist, ist ein sanduhrförmiges Durchgangsloch 5 mit einem Außendurchmesser d2 und einem geringeren Durchmesser d3 an der Taille entstanden. Der Taillendurchmesser d3 kann mit diesem Verfahren über die Ätzzeit eingestellt werden.

Bei hohen Ätzzeiten (z.B. um einen großen Taillendurchmesser d3 zu erreichen) kann es allerdings in einem weniger selektiven Ätzschritt, bei dem das unmodifizierte Material entlang der gesamten Oberfläche des Werkstücks 1 angegriffen wird, zu einer Reduktion der Materialstärke kommen. Dies ist schematisch in Fig. 1d dargestellt, in der die Dicke des Werkstücks 1 nach einem lang andauernden Ätzvorgang mit niedriger Selektivität um 2Δh gegenüber der Dicke des Werkstücks 1 nach einem nur kurz andauernden Ätzvorgang mit niedriger Selektivität verringert ist.

Das Verhältnis des Durchmessers d2 von Eingang/Austritt zum Taillendurchmesser d3 kann mit diesem Verfahren nur über die Selektivität eingestellt werden. Ein derartiges Verfahren mit fester Selektivität ist daher sehr unflexibel.

In Figur 2 ist schematisch eine erste Ausführungsform eines erfindungsgemäßen Verfahrens zum Laserätzen dargestellt. In dieser Ausführungsform werden durch getrennte Ätzvorgänge mit unterschiedlichen Selektivitäten sanduhrförmige Durchgangslöcher mit minimalem Materialverlust entlang der Oberflächen und somit minimaler Reduzierung der Dicke erzeugt. Dazu werden wie in Fig. 2a dargestellt zunächst mehrere langgezogene Modifikationen 2 in das Material des Werkstücks 1 eingebracht. Die Modifikationen 2 erstrecken sich jeweils von einer Oberfläche 3, 3' bis zu einer gewünschten Tiefe oder auch durchgehend von einer Oberfläche 3 zur gegenüberliegenden Oberfläche 3'. Die Modifikationen 2 sind im Wesentlichen über das Volumen verteilt, das in den nachfolgenden Ätzschritten entfernt werden soll, um das sanduhrförmige Durchgangsloch 5 zu erzeugen. In dieser Abbildung wie auch in allen anderen Abbildungen ist jeweils ein Schnitt durch das Werkstück 1 entlang der Strahlausbreitungsrichtung S dargestellt und die Modifikationen 2 liegen in der Schnittebene. Es versteht sich, dass die Modifikationen 2 nicht nur in einer Ebene, sondern auch in einem Volumen verteilt (also vor und/oder hinter der Zeichenebene) angeordnet sein können.

In Fig. 2b ist das Werkstück 1 dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch sind im Werkstück 1 Durchgangslöcher 4 und Sacklöcher 6 mit im Wesentlichen gleichbleibendem Durchmesser entstanden. Zwischen den Durchgangslöchern 4 und den Sacklöcher 6 verbleibt das im ersten Ätzvorgang nicht entfernte unmodifizierte Material in Form von Stegen 7.

Diese Stege 7 werden in einem zweiten Ätzvorgang mit niedriger Selektivität angegriffen und entfernt. Das resultierende Werkstück 1 ist in Fig. 2c dargestellt. Durch die Entfernung des modifizierten Materials und der Stege 7 sind sanduhrförmige Durchgangslöcher 6 entstanden. Somit lassen sich in einem Werkstück 1 sanduhrförmige Durchgangslöcher 6 mit unterschiedlichem Durchmesser innerhalb des gleichen Prozesses erzeugen, da der Durchmesser der Löcher über die Anzahl der Modifikationen 2 und nicht über die Dauer des Ätzvorgangs bestimmt wird. Somit ist auch die resultierende Dicke des Werkstücks nicht abhängig vom zu erzielenden Durchmesser.

Durch das selektive Ätzen wird hier wie auch in den anderen Ausführungsformen ein Ätzzugang für die weniger selektiv wirkende Ätzlösung geschaffen. Dadurch kann der weniger selektive Ätzvorgang gleich über die ganze Länge der im ersten Ätzvorgang entfernten Modifikationen erfolgen und muss sich nicht erst von der Oberfläche des Werkstücks 1 nach innen "vorarbeiten". Die Einwirkzeit der weniger selektiv wirkenden Lösung ist daher so gering, dass kein nennenswerter Materialverlust, insbesondere keine nennenswerte Reduktion der Materialstärke oder aber ein unvermeidbares oberflächennahes Ätzen außerhalb des modifizierten Bereiches stattfindet. Dadurch ist die Erzeugung wohldefinierter Aussparungen und Durchgangslöcher durch Kombination aneinandergereihter Modifikationen möglich. Es gibt keinerlei Beschränkung bezüglich des Winkels oder der Geometrie der Aussparungen und Durchgangslöcher.

In Figur 3 ist schematisch eine zweite Ausführungsform eines erfindungsgemäßen Verfahrens zum Laserätzen dargestellt. Hier reichen langgezogene Modifikationen 2 nur bis zu einer bestimmten Tiefe in das Werkstück 1, wie in Fig. 3a gezeigt. Weitere benachbarte Modifikationen, die ebenfalls nur bis zu dieser Tiefe in das Werkstück reichen, sind vor und/oder hinter der Zeichenebene vorgesehen. Die benachbarten Modifikationen können voneinander beabstandet sein, vorzugsweise mit einem Abstand bis zum fünffachen Durchmesser der einzelnen Modifikationen. In Fig. 3b ist das Werkstück 1 dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch sind im Werkstück 1 Sacklöcher 6 mit im Wesentlichen gleichbleibendem Durchmesser entstanden, zwischen denen Stege (nicht dargestellt) aus unmodifiziertem Material verbleiben.

In einem zweiten Ätzvorgang mit niedriger Selektivität können dann die im ersten Ätzvorgang entstandenen Sacklöcher 6 aufgeweitet werden, so dass die Stege dazwischen entfernt werden. Somit können Gräben 8 im Werkstück 1 erzeugt werden wie in Fig. 3c gezeigt. Durch Anordnung der Modifikationen 2 entlang von beliebigen Geometrien können durch die Kombination von selektivem und weniger selektivem Ätzen beliebige Geometrien von Gräben im Werkstück erzeugt werden.

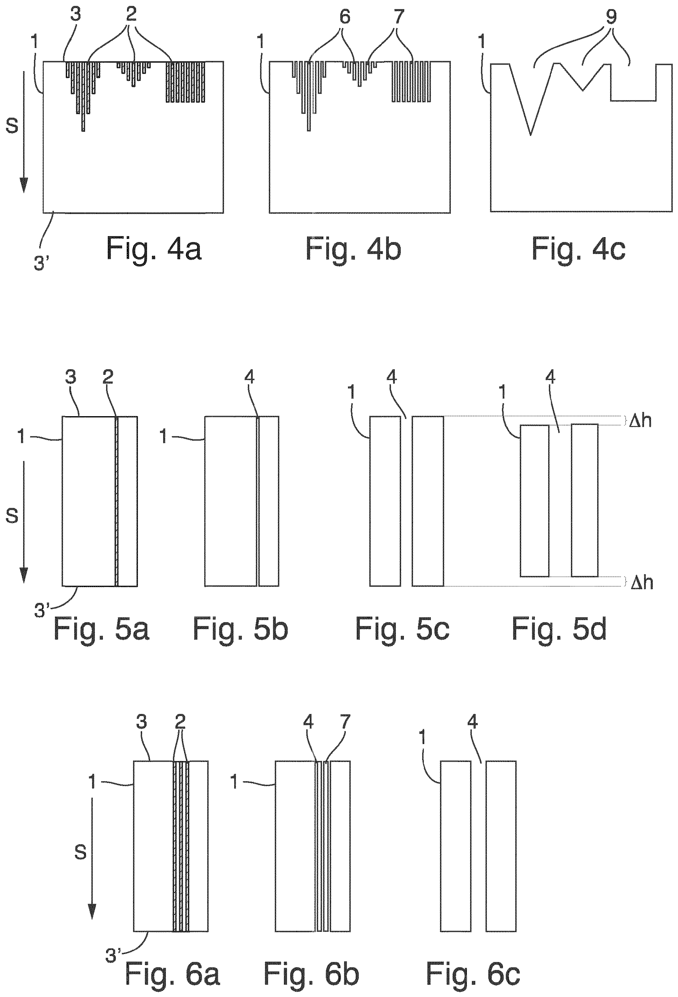

In Figur 4 ist schematisch eine dritte Ausführungsform eines erfindungsgemäßen Verfahrens zum Laserätzen dargestellt. In dieser Ausführungsform werden durch getrennte Ätzvorgänge mit unterschiedlichen Selektivitäten Aussparungen 9 an einer der Oberflächen 3 des Werkstücks 1 erzeugt. Dazu werden wie in Fig.4a dargestellt zunächst mehrere langgezogene Modifikationen 2 in das Material des Werkstücks 1 eingebracht. Die Modifikationen 2 erstrecken sich jeweils von einer Oberfläche 3 bis zu einer gewünschten Tiefe. Dabei können die Modifikationen 2 für eine Aussparung 9 unterschiedliche Längen haben (siehe links und Mitte) oder auch die gleiche Länge haben (siehe rechts). Die Modifikationen 2 sind im Wesentlichen über das Volumen angeordnet, das in den nachfolgenden Ätzschritten entfernt werden soll, um die Aussparung 9 zu erzeugen. In dieser Abbildung wie auch in allen anderen Abbildungen ist jeweils ein Schnitt durch das Werkstück 1 dargestellt und die Modifikationen 2 liegen in der Schnittebene. Es versteht sich, dass die Modifikationen 2 nicht nur in einer Ebene, sondern auch in einem Volumen verteilt angeordnet sein können.

In Fig. 4b ist das Werkstück 1 dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch sind im Werkstück 1 Sacklöcher 6 mit im Wesentlichen gleichbleibendem Durchmesser entstanden. Zwischen den Sacklöcher 6 verbleibt das im ersten Ätzvorgang nicht entfernte unmodifizierte Material in Form von Stegen 7.

Diese Stege 7 werden in einem zweiten Ätzvorgang mit niedriger Selektivität angegriffen und entfernt. Das resultierende Werkstück 1 ist in Fig. 4c dargestellt. Durch die Entfernung des modifizierten Materials und der Stege 7 sind Aussparungen 9 entstanden (im gezeigten Beispiel mit dreieckigem (links und Mitte) bzw. rechteckigem (rechts) Querschnitt, also beispielsweise kegel- und quaderförmig). Somit lassen sich in einem Werkstück 1 Aussparungen 9 mit unterschiedlichen Formen innerhalb des gleichen Prozesses erzeugen.

In Figur 5 ist schematisch eine vierte Ausführungsform eines erfindungsgemäßen Verfahrens zum Laserätzen dargestellt. In dieser Ausführungsform werden durch getrennte Ätzvorgänge mit unterschiedlichen Selektivitäten Durchgangslöcher 4 durch das Werkstück 1 mit gleichbleibendem Durchmesser erzeugt. Dazu wird wie in Fig. 5a dargestellt zunächst eine langgezogene Modifikation 2 in das Material des Werkstücks 1 eingebracht. Die Modifikation 2 erstreckt sich durchgehend von einer Oberfläche 3 zur gegenüberliegenden Oberfläche 3'.

In Fig.5b ist das Werkstück 1 dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch ist im Werkstück 1 ein Durchgangsloch 6 mit im Wesentlichen gleichbleibendem Durchmesser (entsprechend dem Durchmesser der Modifikation, beispielsweise kleiner als 500 nm) entstanden.

In einem anschließenden zweiten Ätzvorgang mit niedriger Selektivität wird der Durchmesser des Durchgangslochs 4 bis zum gewünschten Durchmesser vergrößert wie in Fig. 5c dargestellt. Dadurch dass die Ätzlösung im zweiten Ätzvorgang von Anfang an über die gesamte Dicke des Werkstücks 1 angreifen kann, erfolgt die Aufweitung des Durchgangslochs 4 gleichmäßig über dessen Länge. Die Aufweitung des Durchgangslochs 4 kann über den zeitlichen Angriff der weniger selektiven Ätzlösung festgelegt werden. Auch hier kann es bei zu langem Ätzangriff zur Reduktion der Materialstärke kommen, wie in Fig. 5d gezeigt.

Eine weitere Ausführungsform eines erfindungsgemäßen Verfahrens, mit dem Durchgangslöcher 4 mit gleichbleibendem Durchmesser erzeugt werden können, ist schematisch in Figur 6 dargestellt. Diese Ausführungsform bietet eine höhere Flexibilität hinsichtlich des Durchmessers der Durchgangslöcher 4 ohne übermäßigen Materialverlust und damit ohne übermäßige Dickenreduzierung des Werkstücks 1. Hierzu werden wie in Fig. 6a dargestellt zunächst mehrere langgezogene Modifikationen 2 in das Material des Werkstücks 1 eingebracht. Die Modifikationen 2 erstrecken sich jeweils durchgehend von einer Oberfläche 3 zur gegenüberliegenden Oberfläche 3'. Die Modifikationen 2 sind im Wesentlichen über das Volumen angeordnet, das in den nachfolgenden Ätzschritten entfernt werden soll, um das Durchgangsloch 4 zu erzeugen. In dieser Abbildung wie auch in allen anderen Abbildungen ist jeweils ein Schnitt durch das Werkstück 1 dargestellt und die Modifikationen 2 liegen in der Schnittebene. Es versteht sich, dass die Modifikationen 2 nicht nur in einer Ebene, sondern auch in einem Volumen verteilt angeordnet sein können.

In Fig. 6b ist das Werkstück 1 dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch sind im Werkstück 1 Durchgangslöcher 4 mit im Wesentlichen gleichbleibendem Durchmesser (entsprechend dem Durchmesser der Modifikation, beispielsweise kleiner als 500 nm, in Glas häufig etwa 1 µm) entstanden. Zwischen den Durchgangslöchern 4 verbleibt das im ersten Ätzvorgang nicht entfernte unmodifizierte Material in Form von Stegen 7.

Diese Stege 7 werden in einem zweiten Ätzvorgang mit niedriger Selektivität angegriffen und entfernt. Das resultierende Werkstück 1 ist in Fig. 6c dargestellt. Durch die Entfernung des modifizierten Materials und der Stege 7 sind Durchgangslöcher 4 mit gleichbleibendem Durchmesser entstanden. Somit lassen sich in einem Werkstück 1 mehrere Durchgangslöcher 4 mit jeweils unterschiedlichem Durchmesser innerhalb des gleichen Prozesses erzeugen, da der Durchmesser der Löcher über die Anzahl der Modifikationen 2 und nicht über die Dauer des Ätzvorgangs bestimmt wird. Somit ist auch die resultierende Dicke des Werkstücks nicht abhängig vom zu erzielenden Durchmesser.

Eine schematische Darstellung eines Werkstücks, das mit einem erfindungsgemäßen Verfahren hergestellt wurde, ist in Fig. 7 gezeigt. In das aus beispielsweise Glas oder Saphir bestehende Werkstück 1 wurden mehrere Durchgangslöcher 4 mit gleichbleibendem Durchmesser über ihre Länge eingebracht. Ein Querschnitt durch das Werkstück 1 in einer Ebene A, in der sich mehrere Durchgangslöcher 4 befinden, ist in Fig. 7a gezeigt. Es ist zu sehen, dass sich die Durchgangslöcher von einer Oberfläche 3 des Werkstücks 1 zur gegenüberliegenden Oberfläche 3' erstrecken. Durch das erfindungsgemäße Verfahren mit einem ersten Ätzschritt mit hoher Selektivität und einem zweiten Ätzschritt mit niedriger Selektivität können die Durchgangslöcher mit einem beliebigen und dennoch über ihre Länge im Wesentlichen konstanten Durchmesser erzeugt werden. Eine Draufsicht auf das Werkstück 1 ist in Fig. 7b gezeigt. Hier ist zu sehen, dass das Werkstück 1 nicht nur Durchgangslöcher 4 in der Ebene A aufweist, sondern auch in zur Ebene A parallelen Ebenen. Abstand, Anzahl, Anordnung und Durchmesser der Durchgangslöcher 4 kann beliebig eingestellt werden. Ein solches Werkzeug kann beispielsweise als Nanosieb oder Mikrosieb Verwendung finden. Die Abmessungen des Werkstücks 1 in dieser wie in den anderen Abbildungen ist nicht maßstabsgerecht. Insbesondere kann das Werkstück eine Dicke haben, die sehr viel geringer ist als seine sonstigen Abmessungen wie Länge und Breite.

In Figur 8 ist schematisch eine sechste Ausführungsform eines erfindungsgemäßen Verfahrens zum Laserätzen dargestellt. Das Verfahren wird hier anhand einer Draufsicht auf das Werkstück 1 erläutert. In dieser Ausführungsform wird durch getrennte Ätzvorgänge mit unterschiedlichen Selektivitäten ein Teil des Werkstücks 1 vom Rest des Werkstücks abgetrennt. Dazu werden wie in Fig. 8a dargestellt zunächst mehrere langgezogene Modifikationen 2 in das Material des Werkstücks 1 eingebracht. Die Modifikationen 2 erstrecken sich durchgehend von einer Oberfläche 3 zur gegenüberliegenden Oberfläche 3'. Die Modifikationen 2 sind entlang einer Kontur 10, die hier als Kreis dargestellt ist, angeordnet. Der Ausschnitt D wird in den Figuren 8b, 8c und 8d vergrößert gezeigt.

In Fig. 8b ist das Werkstück 1 ausschnittweise dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch sind im Werkstück 1 Durchgangslöcher 4 ausgebildet. Zwischen den Durchgangslöchern 4 verbleibt das im ersten Ätzvorgang nicht entfernte unmodifizierte Material in Form von Stegen 7.

Diese Stege 7 werden in einem zweiten Ätzvorgang mit niedriger Selektivität angegriffen und entfernt wie ausschnittsweise in Fig. 8c gezeigt. Je nach Dauer des zweiten Ätzvorgangs kann die Breite des dadurch zwischen dem abzutrennenden Teil des Werkstücks 1 und dem Rest des Werkstücks 1 entstehenden Spalts 11 eingestellt werden. Während des Ätzvorgangs mit niedriger Selektivität wird im Normalfall auch der Durchmesser der im ersten Ätzvorgang entstandenen Durchgangslöcher 4 vergrößert. Dies ist in der vorliegenden schematischen Zeichnung nicht dargestellt. Auch können abhängig beispielsweise vom Abstand zwischen jeweils zwei Modifikationen zwischen diesen Modifikation Mikrorisse während des Ätzens des modifizierten Materials entstehen, durch die der zweite Ätzvorgang mit niedriger Selektivität bevorzugt entlang der Kontur 10 verläuft. In Fig. 8d ist das Werkstück 1 ausschnittsweise nach einer längeren Einwirkzeit des zweiten Ätzvorgangs als in Fig. 8c dargestellt. Die im ersten Ätzvorgang erzeugten Durchgangslöcher 4 dienen dabei als Zugang für die Ätzlösung des zweiten Ätzvorgangs, welche somit von Anfang an über die gesamte Dicke des Werkstücks 1 wirken kann, sodass der Spalt 11 über die Dicke des Werkstücks 1 eine im Wesentlichen gerade Form hat.

Das Werkstück 1 nach dem Entfernen des abgetrennten Teils ist in Fig. 8e dargestellt. Das vorliegende Verfahren erlaubt somit auch Abtrennen oder Herauslösungen von Teilen eines Werkstücks aus dessen Inneren.

In Figur 9 ist schematisch eine siebte Ausführungsform eines erfindungsgemäßen Verfahrens zum Laserätzen dargestellt. In dieser Ausführungsform wird ein Werkstück 1 in zwei Teile mit abgerundeten Kanten 12 geteilt. Dazu werden wie in Fig.9a dargestellt zunächst mehrere langgezogene Modifikationen 2 über die gesamte Dicke des Werkstücks 1 in das Material des Werkstücks 1 eingebracht. In Fig. 9a ist nur eine Modifikation 2 dargestellt, die weiteren Modifikationen sind benachbart in Ebenen parallel zur Zeichnungsebene angeordnet. Benachbarte Modifikationen können überlappend oder nicht-überlappend ausgebildet sein, wie oben mit Bezug auf Fig. 3 beschrieben. In einer Ausführungsform haben die Modifikationen einen Durchmesser von etwa 1 µm und einen Abstand von mindestens 1 µm, sodass sich benachbarte Modifikationen nicht überlappen, sondern höchstens gerade berühren.

In Fig. 9b ist das Werkstück 1 dargestellt, nachdem in einem ersten Ätzvorgang mit niedriger Selektivität sowohl das modifizierte Material (teilweise) als auch das unmodifizierte Material von der Ätzlösung angegriffen und entfernt wurde. Dadurch entsteht ein Graben 8 oder (je nach Abstand der Modifikationen und Dauer des ersten Ätzvorgangs) eine Abfolge von trichterförmigen Vertiefungen auf beiden Oberflächen 3, 3' entlang der Reihe von Modifikationen 2. Da auch bei einem Ätzvorgang mit niedriger Selektivität bevorzugt das modifizierte Material angegriffen wird verläuft der Graben 8 entlang der Reihe von Modifikationen 2. Wenn benachbarte Modifikationen nicht-überlappend (d.h. voneinander beabstandet) sind, kann in einer weiteren Ausführungsform (nicht dargestellt) zusätzlich eine weitere durchgehende Modifikation entlang der Kontur eingebracht werden, die beispielsweise nur über die Tiefe der gewünschten Verrundung der Kanten in das Material des Werkstücks reicht. Während des ersten Ätzvorgangs entsteht dann entlang dieser durchgehenden Modifikation ein Graben mit abgerundeten Kanten.

In einem anschließenden zweiten Ätzvorgang mit hoher Selektivität wird dann (überwiegend) nur das modifizierte Material entfernt, sodass die beiden Teile des Werkstücks voneinander getrennt werden können, wie in Fig. 9c gezeigt. Die runden Wände des Grabens 8 ergeben jetzt jeweils abgerundete Kanten 12 der beiden Teile des Werkstücks 1.

In einer nicht dargestellten Ausführungsform kann mit einem erfindungsgemäßen Verfahren entsprechend dem Verfahren der Fig. 9 auch eine Verrundung der Öffnung von Durchgangslöchern und Sacklöchern oder der Kanten von Gräben erreicht werden, indem den entsprechenden, vorstehend beschriebenen Verfahren ein Ätzvorgang mit geringer Selektivität vorangestellt wird, in dem eine trichterförmige Vertiefung um die Modifikation erzeugt wird.

Die Kanten können noch durch einen weiteren kurzen Ätzvorgang mit niedriger Selektivität begradigt und somit poliert werden.

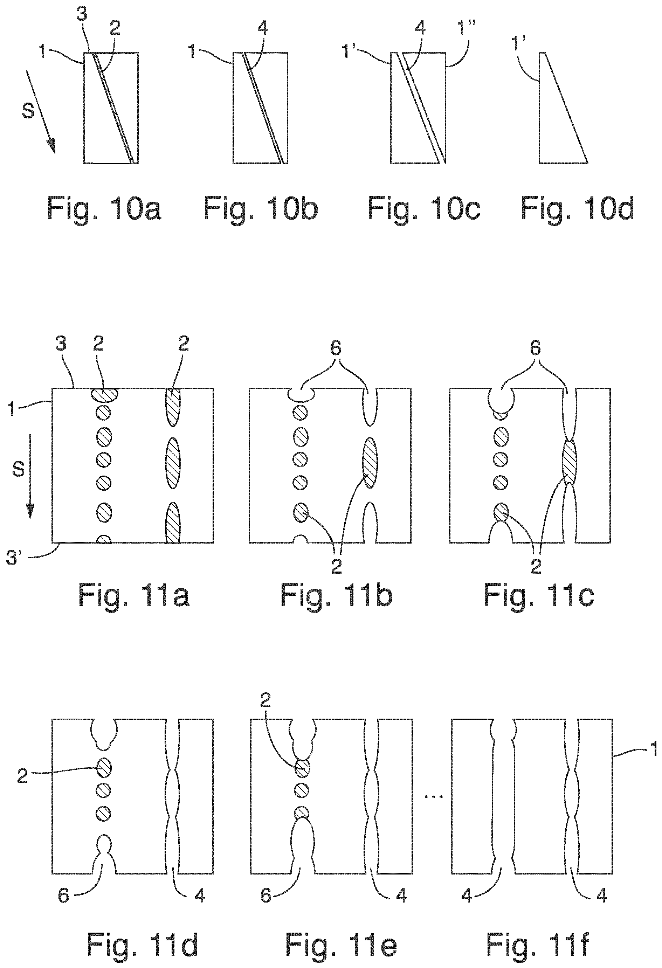

In Fig. 10 ist schematisch eine achte Ausführungsform eines erfindungsgemäßen Verfahrens zum Laserätzen dargestellt. In dieser Ausführungsform wird ein Werkstück 1 in zwei Teile geteilt. Dazu werden wie in Fig. 10a dargestellt zunächst mehrere langgezogene Modifikationen 2 schräg durch das Werkstück 1 hindurch über die gesamt Dicke des Werkstücks 1 in das Material des Werkstücks 1 eingebracht. In Fig. 10a ist nur eine Modifikation 2 dargestellt, die weiteren Modifikationen sind benachbart in Ebenen parallel zur Zeichnungsebene angeordnet. Benachbarte Modifikationen können überlappend oder nicht-überlappend ausgebildet sein, wie oben mit Bezug auf Fig. 3 beschrieben. In einer Ausführungsform haben die Modifikationen einen Durchmesser von etwa 1 µm und einen Abstand von mindestens 1 µm, sodass sich benachbarte Modifikationen nicht überlappen, sondern höchstens gerade berühren. Jede der langgezogenen Modifikationen 2 kann entweder mittels eines auf die Oberfläche 3 des Werkstücks 1 schräg einfallenden Laserstrahls mit longitudinal ausgedehntem Intensitätsprofil (z.B. eines Bessel-Strahls mit langgezogener Fokuszone) oder durch treppenförmiges Aneinanderreihen mehrerer Modifikationen erzeugt werden. Letzteres kann insbesondere bei größerem Winkel vorteilhaft sein.

Mehrere treppenförmig aneinandergereihte Modifikationen können beispielsweise nacheinander durch einen Bessel-Strahl mit kurzer Fokuszone in unterschiedlichen Abständen von der Oberfläche 3 des Werkstücks 1 (oder entsprechend durch einen Gauß-Strahl mit einem Fokus in unterschiedlichen Abständen von der Oberfläche 3 des Werkstücks 1) erzeugt werden. Der unterschiedliche Abstand der Fokuszone zur Oberfläche des Werkstücks kann beispielsweise durch ein Einstellen des Abstands zwischen Laser und Werkstück oder durch unterschiedliche Strahlformung des Laserstrahls erreicht werden. Mehrere treppenförmig aneinandergereihte Modifikationen können auch durch einen sogenannten Multispot-Laserstrahl erzeugt werden, der durch Strahlformung beispielsweise so ausgebildet ist, dass er eine Ausdehnung in einer Richtung senkrecht zur Strahlrichtung aufweist, wobei die Fokusposition entlang der Richtung senkrecht zur Strahlrichtung variiert. Ein solcher Strahl kann auch als mehrere parallele Strahlen mit jeweils unterschiedlicher Fokusposition angesehen werden. Die in Fig. 10a angegebene Strahlrichtung S entspricht der Variante mit einem angestellten Bessel-Strahl.

In Fig. 10b ist das Werkstück 1 dargestellt, nachdem in einem ersten Ätzvorgang mit hoher Selektivität das modifizierte Material von der Ätzlösung angegriffen und entfernt wurde. Durch die hohe Selektivität des Ätzvorgangs wurde das unmodifizierte Material nicht oder nur unwesentlich angegriffen. Dadurch sind im Werkstück 1 Durchgangslöcher 4 ausgebildet. Zwischen den Durchgangslöchern 4 verbleibt das im ersten Ätzvorgang nicht entfernte unmodifizierte Material in Form von Stegen (nicht dargestellt).

Diese Stege werden in einem zweiten Ätzvorgang mit niedriger Selektivität angegriffen und entfernt wie in Fig. 10c gezeigt. Dadurch wird das Werkstück 1 in zwei Teile 1', 1" geteilt. Während des Ätzvorgangs mit niedriger Selektivität werden die im ersten Ätzvorgang entstandenen Durchgangslöcher 4 vergrößert und die Stege dazwischen entfernt. Auch können abhängig beispielsweise vom Abstand zwischen jeweils zwei Modifikationen zwischen diesen Modifikation Mikrorisse während der Modifizierung des Materials entstehen, durch die der zweite Ätzvorgang mit niedriger Selektivität bevorzugt durch die Stege verläuft.

In Fig. 10d ist das Werkstück 1 dargestellt, nachdem der abgetrennte Teil 1" entfernt wurde.

In Figur 11 ist schematisch eine neunte Ausführungsform eines erfindungsgemäßen Verfahrens zum Laserätzen dargestellt. Je nach Prozess- und/oder Materialparametern können unterschiedlichste Materialmodifikationen auftreten. Wenn keine durchgängig modifizierten Bereiche über die Dicke des Werkstücks möglich oder erwünscht sind, kann selektiv kein durchgängiges Ätzen stattfinden. Beispielsweise können runde oder längliche Materialmodifikationen in Strahlausbreitungsrichtung kettenartig angeordnet sein (longitudinale Multispots) wie in Fig. 11a dargestellt. Gerade wenn Spannungen beim Modifizieren möglichst gering sein sollen, können Multispot-Modifikationen gegenüber langegezogenen, durchgängigen Modifikationen vorteilhaft sein.

Um in solchen Fällen trotzdem ein Durchgangsloch 4 durch das Werkstück 1 insbesondere mit möglichst konstantem Durchmesser erzeugen zu können, kann mehrmals zwischen einem Ätzvorgang mit hoher Selektivität und einem Ätzvorgang mit niedriger Selektivität abgewechselt werden. Während der Ätzvorgänge mit hoher Selektivität wird das von außen für die Ätzlösung zugängliche modifizierte Material entfernt (siehe Fig. 11b und Fig. 11d). Durch die hohe Selektivität des Ätzvorgangs wird das unmodifizierte Material dabei nicht oder nur unwesentlich angegriffen. Dadurch kann eine unerwünschte Aufweitung des Durchmessers möglichst vermieden werden.

Während der Ätzvorgänge mit niedriger Selektivität wird auch das unmodifizierte Material entfernt, sodass danach wieder das modifizierte Material zugänglich ist (siehe Fig. 11c und Fig. 11e). Im nächsten Ätzvorgang mit hoher Selektivität wird dann wieder das für die Ätzlösung zugängliche modifizierte Material entfernt. Nach mehrmaligem Abwechseln der Ätzvorgange mit hoher Selektivität und mit niedriger Selektivität entsteht dann ein Durchgangsloch 4 durch das Werkstück 1 wie in Fig. 11f gezeigt.

Durch ein derartiges alternierendes Ätzen, d.h. abwechselnde Ätzvorgänge mit hoher und mit niedriger Selektivität kann sichergestellt werden, dass Durchgangslöcher wie auch Sacklöcher die gewünschte Länge aufweisen, selbst wenn die Modifikation in Längsrichtung nicht vollkommen homogen ausgebildet ist.

Mit den hier vorgestellten Verfahren können beliebige Durchmesser von Durchgangslöchern und Aussparungen von einigen hundert Nanometern bis zu mehreren Millimetern erzeugt werden. Da der Materialverlust durch Ätzen mit geringer Selektivität minimal gehalten werden kann, sind die erreichbaren Abmessungen nicht von der Materialstärke des Werkstücks abhängig.

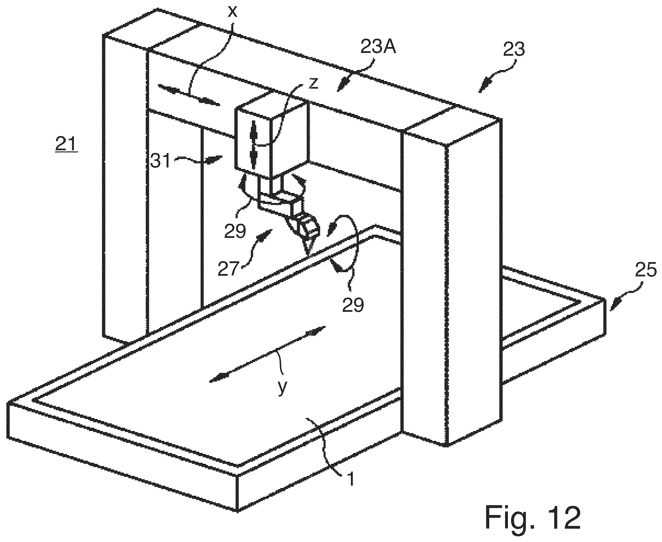

In der in Fig. 12 gezeigten Laserbearbeitungsanlage 21 kann ein optisches System 31 beispielsweise für die Modifizierung des Materials eines Werkstücks 1 eingesetzt werden. Die Laserbearbeitungsanlage 21 weist ein Trägersystem 23 und eine Werkstücklagerungseinheit 25 auf. Das Trägersystem 23 überspannt die Werkstücklagerungseinheit 25 und trägt ein Lasersystem, welches in Fig. 12 beispielsweise in einem oberen Querträger 23A des Trägersystems 23 integriert ist. Ferner ist das optische System 31 in X-Richtung verfahrbar am Querträger 23A angebracht, so dass beide Komponenten ortsnah zueinander angeordnet sind. In alternativen Ausführungsformen kann beispielsweise das Lasersystem als eigene externe Einheit vorgesehen werden, dessen Laserstrahl zum optischen System 31 mittels Lichtleitfasern oder als Freistrahl geführt wird.

Die Werkstücklagerungseinheit 25 trägt ein sich in der X-Y-Ebene erstreckendes Werkstück 1, beispielsweise eine Glasscheibe oder eine für die eingesetzte Laserwellenlänge weitgehend transparente Scheibe in keramischer oder kristalliner Ausführung wie beispielsweise Saphir oder Silizium. Die Werkstücklagerungseinheit 25 erlaubt ein Verfahren des Werkstücks in Y-Richtung relativ zum Trägersystem 23, so dass in Kombination mit der Verfahrbarkeit des optischen Systems 31 ein sich in der X-Y-Ebene erstreckender Bearbeitungsbereich zur Verfügung steht.

Gemäß Fig. 12 ist ferner eine Verschiebbarkeit in Z-Richtung z.B. des optischen Systems 31 oder des Querträgers 23A vorgesehen, um den Abstand zum Werkstück einstellen zu können. Für eine in Z-Richtung verlaufende Modifikation wird der Laserstrahl üblicherweise auch in Z-Richtung (d.h. normal) auf das Werkstück gerichtet. Allerdings können weitere Bearbeitungsachsen bereitgestellt werden, wie es in Fig. 12 beispielhaft durch eine Auslegeranordnung 27 und den zusätzlichen Rotationsachsen 29 angedeutet wird. Entsprechend ist die Auslegeranordnung 27 in der Ausführung gemäß Fig. 12 optional. Ferner können redundante Zusatzachsen für eine höhere Dynamik vorgesehen werden, indem z.B. nicht das Werkstück oder das optische System, sondern kompaktere und entsprechend konzipierte Komponente beschleunigt werden.

Die Laserbearbeitungsanlage 21 weist ferner eine nicht explizit gezeigte Steuerung auf, die beispielsweise im Trägersystem 23 integriert ist und insbesondere eine Schnittstelle zur Eingabe von Betriebsparametern durch einen Benutzer aufweist. Allgemein umfasst die Steuerung Elemente zum Ansteuern von elektrischen, mechanischen und optischen Komponenten der Laserbearbeitungsanlage 21, beispielsweise durch Ansteuern entsprechender Betriebsparameter, wie z.B. Pumplaserleistung, Kühlleistung, Richtung und Geschwindigkeit der Laseranlage und/oder der Werkstückhalterung, elektrische Parameter für die Einstellung eines optischen Elements (beispielsweise eines SLM) und die räumliche Ausrichtung eines optischen Elements (beispielsweise zur Drehung desselben).

Weitere Anordnungen für Laserbearbeitungsanlagen mit verschiedensten Freiheitsgraden sind beispielsweise in EP 1 688 807 A1 offenbart. Allgemein wird bei kleinen Werkstücken oft nur das Werkstück bewegt und bei eher großen Werkstücken nur der Laserstrahl oder - wie in Fig. 12 - das Werkstück und der Laserstrahl. Überdies können zwei oder mehrere optische Systeme und damit Fokuszonen von einem Lasersystem versorgt werden.

Die durch Laserbearbeitungsanlagen erzeugten Modifikationen im Material können für selektives Laserätzen eingesetzt werden. Dementsprechend ist es wichtig sowohl die Geometrie als auch die Art der Modifikation geeignet kontrollieren zu können. Neben Parametern wie Laserwellenlänge, zeitliche Pulsform, Anzahl der Pulse, Energie und zeitlicher Abstand der Pulse in einer eine einzelne Modifikation erzeugenden Pulsgruppe sowie Pulsenergie bzw. Pulsgruppenenergie spielt dabei die Strahlform eine entscheidende Rolle.

Insbesondere eine langgezogene Volumenmodifikation erlaubt eine Bearbeitung über einen in Strahlausbreitungsrichtung lang ausgedehnten Volumenbereich in einem einzigen Bearbeitungsschritt. Insbesondere kann an einem Ort in Vorschubrichtung die Bearbeitung über eine große Ausdehnung in nur einem einzigen Modifikationsbearbeitungsschritt stattfinden.

Ferner kann eine langgezogene Fokuszone hilfreich bei der Bearbeitung von unebenen Materialien sein, da im Wesentlichen identische Laserbearbeitungsbedingungen entlang der langgezogenen Fokuszone vorherrschen, so dass in derartigen Ausführungsformen ein entsprechendes Nachführen in Ausbreitungsrichtung nicht oder nur ab eine größeren Abweichung der Position des zu bearbeitenden Materials als der Länge des langgezogenen Fokusbereichs (unter Berücksichtigung der benötigten Bearbeitungs-/Eindringtiefe) notwendig werden kann.

Allgemein gilt für die Bearbeitung transparenter Werkstoffe mittels langgezogener Volumenabsorption, dass, sobald eine Absorption stattfindet, diese Absorption selbst oder aber die resultierende Änderung der Materialeigenschaft die Propagation des Laserstrahls beeinflussen kann. Deshalb ist es vorteilhaft, wenn Strahlanteile, die eine Modifikation tiefer im Werkstück, also in Strahlausbreitungsrichtung strahlabwärts, bewirken sollen, im Wesentlichen nicht durch Bereiche nennenswerter Absorption geführt werden.

In anderen Worten ist es also günstig, die zur Modifikation weiter strahlabwärts dienenden Strahlanteile unter einem Winkel der Wechselwirkungszone zuzuführen. Ein Beispiel hierfür ist der Quasi-Bessel-Strahl, bei dem eine ringförmige Fernfeldverteilung vorliegt, deren Ringbreite typischerweise klein im Vergleich zum Radius ist. Die Strahlanteile der Wechselwirkungszone werden dabei im Wesentlichen mit diesem Winkel rotationssymmetrisch zugeführt. Das gleiche gilt für den einen inversen Quasi-Bessel-Strahl oder für Modifikationen und Ergänzungen desselben wie den homogenisierten oder modulierten inversen Quasi-Bessel-Strahl. Ein weiteres Beispiel ist der inverse beschleunigte "Quasi-Airy-Strahl-artige" Strahl, bei dem die Strahlanteile der Modifikation unter einem Offsetwinkel zugeführt werden, wobei dies anschaulich tangential und - nicht wie beim reinen Quasi-Bessel-Strahl rotationssymmetrisch - an die gekrümmte Modifikationszone erfolgt, z.B. wie bei einem gekrümmten inversen Quasi-Bessel-Strahl.

Weiterhin ist es anzustreben, die Schwelle für die nichtlineare Absorption nur in dem angestrebten Volumenbereich nennenswert zu überschreiten und die Geometrie dieses Volumenbereichs so zu wählen, dass diese einerseits für die gewünschte Anwendung geeignet ist, andererseits aber auch die Propagation zu weiter strahlabwärts liegenden Volumenbereichen nicht wesentlich stört. Beispielsweise mag es vorteilhaft sein, Nebenmaxima eines apodisierten Bessel-Strahlprofils unterhalb einer für die nichtlineare Absorption benötigte Schwellenintensität zu halten.

Mit Blick auf in Vorschubrichtung aufeinanderfolgende Modifikationen kann die Geometrie des modifizierten Volumens ferner so gewählt werden, dass bei einer Aufreihung in Vorschubrichtung mehrerer Modifikationen eine vorher eingebrachte Modifikation nur einen unbedeutenden Einfluss auf die Ausbildung der nachfolgenden Modifikationen hat.

Für eine schnelle Bearbeitung kann die Erzeugung einer einzelnen Modifikation mit nur einem einzelnen Laserpuls/einer einzigen Laserpulsgruppe erfolgen, so dass eine Position am Werkstück in diesem Fall nur einmal angefahren wird.

Ultrakurzpulslaser können die Bereitstellung von Intensitäten (Leistungsdichten) ermöglichen, die es erlauben, eine ausreichend starke Materialmodifikation in entsprechend langen Wechselwirkungszonen zu verursachen. Die geometrische Ausdehnung der Modifikation wird dabei mithilfe der Strahlformung derart festgelegt, dass eine lang ausgedehnte, hohe freie Elektronendichte durch nichtlineare Absorption im Material erzeugt wird. Die Zuführung der Energie in tiefere Bereiche erfolgt lateral, so dass der Abschirmungseffekt durch eine vorgelagerte Wechselwirkung des Plasmas im Vergleich mit einer Gaußschen Fokussierung verhindert wird. Es kann beispielsweise eine in longitudinaler Richtung gleichmäßig ausgedehnte Elektronendichte oder eine räumlich hochfrequent modulierte Elektronendichte erzeugt werden.

Bei entsprechenden Intensitäten kann es in Gebieten mit ausreichend hoher freier Elektronendichte zu einer explosionsartigen Ausdehnung des Materials kommen, wobei die dabei entstehende Schockwelle nanoskopische Löcher (Nanovoids) erzeugen kann. Weitere Beispiele für Modifikationen (Modifikationszonen) sind Brechungsindexänderungen, komprimierte und/oder zugspannungsinduzierende Bereiche, Mikrokristallite und lokale Stöchiometrieänderungen.

Die Modifikationsgeometrie wird dabei schwerpunktmäßig durch die Strahlformung bestimmt (und nicht durch nichtlineare Propagation wie beispielsweise der Filamentation). Die Erzeugung räumlicher Gradienten kann durch die optischen Systeme erfolgen, die der zeitlichen Gradienten kann durch Pulszüge oder Pulsformung erzeugt werden.

Allgemein kann eine Skalierung der Intensitätsverteilung einer Strahlform durch das Abbildungsverhältnis des Systems, insbesondere durch die Brennweite und die Numerische Apertur der Nahfeldoptik des Abbildungssystems erfolgen. Weitere Möglichkeiten zur Skalierung ergeben sich aus der Verwendung einer zusätzlichen Linse sowie der Verschiebung des Strahlformungselements und/oder der Fernfeldoptik. Dadurch kann die laterale und longitudinale Ausdehnung des Strahlprofils im Werkstück beeinflusst werden. Ferner können im Strahlengang zur Strahlformung Raumfilter und Blenden verwendet werden, um den Strahl aufzubereiten.

Beispielhafte Laserstrahlparameter für z.B. Ultrakurzpulslasersysteme und Parameter des optischen Systems und der langgezogenen Fokuszone, die im Rahmen dieser Offenbarung eingesetzt werden können, sind:
Pulsenergie Eₚ: 1 µJ bis 10 mJ (z.B. 20 µJ bis 1000 µJ),
Energie einer Pulsgruppe E_{g}: 1 µJ bis 10 mJ
Wellenlängenbereiche: IR, VIS, UV (z.B. 2 µm > λ > 200 nm; z.B. 1550nm, 1064 nm, 1030 nm, 515 nm, 343 nm)
Pulsdauer (FWHM): 10 fs bis 50 ns (z.B. 200 fs bis 20 ns)
Einwirkdauer (abhängig von Vorschubgeschwindigkeit): kleiner 100 ns (z.B. 5 ps - 15 ns)
Tastverhältnis (Einwirkdauer zur Repetitionszeit des Laserpulses/der Pulsgruppe): kleiner gleich 5 %, z.B. kleiner gleich 1 %
Rohstrahldurchmesser D (1/e²) bei Eintritt in optisches System: z.B. im Bereich von 1 mm bis 25 mm
Brennweite der Nahfeldoptik: 3 mm bis 100 mm (z.B. 10 mm bis 20 mm)
Numerische Apertur NA der Nahfeldoptik: 0.15 ≤ NA ≤ 0.5
Länge des Strahlprofils im Material: größer 20 µm
Maximale laterale Ausdehnung des Strahlprofils im Material, ggf. in der kurzen Richtung: kleiner 20 λ
Aspektverhältnis: größer 20
Modulation in Ausbreitungsrichtung: größer 10 Perioden über Fokuszone
Vorschub dᵥ zwischen zwei benachbarten Modifikationen z.B. für trennende Anwendung:
   100 nm < dᵥ < 10 * laterale Ausdehnung in Vorschubrichtung
   Vorschub während Einwirkdauer: z.B. kleiner 5 % der lateralen Ausdehnung in Vorschubrichtung

Dabei bezieht sich die Pulsdauer auf einen Laserpuls und die Einwirkdauer auf einen zeitlichen Bereich, in dem z.B. eine Gruppe von Laserpulsen zur Bildung einer einzigen Modifikation an einem Ort mit dem Material wechselwirkt. Dabei ist die Einwirkdauer kurz hinsichtlich der vorliegenden Vorschubgeschwindigkeit, so dass alle Laserpulse eine Gruppe zu einer Modifikation an einem Ort beitragen.

Ist das Werkstück dünner als die Fokuszone lang ist, liegt die Fokuszone partiell außerhalb des Werkstücks, so dass sich Modifikationen ergeben können, die kürzer als die Fokuszone sind. Eine derartige Situation kann vorteilhaft ausgenutzt werden, um den Bearbeitungsprozess auch bei einem Variieren des Abstands zwischen Optik und Werkstück robust zu gestalten. In einigen Ausführungsformen kann eine nicht durch das gesamte Werkstück reichende Modifikation vorteilhaft sein. Insbesondere kann die Länge der Fokuszone und/oder deren Lage im Werkstück angepasst werden. Allgemein sei dabei angemerkt, dass aufgrund unterschiedlicher Schwellen für die nichtlineare Absorption eine Fokuszone mit angenommener identischer Intensität unterschiedlich große Modifikationen in verschiedenen Materialien bewirken wird.

Das Aspektverhältnis betrifft die Geometrie des Strahlprofils (der Fokuszone) im zu bearbeitenden Material sowie die Geometrie der mit einem Strahlprofil erzeugten Modifikation. Bei asymmetrischen oder in lateraler Richtung modulierten (beispielsweise nicht rotationssymmetrischen oder ringförmigen) Strahlprofilen ist das Aspektverhältnis durch das Verhältnis der Länge der Modifikation zu einer innerhalb diesem Längenbereich auftretenden maximalen lateralen Ausdehnung in der kürzesten Richtung bestimmt. Weist das Strahlprofil dabei eine Modulation in lateraler Richtung auf, z.B. bei ringförmigen Strahlprofilen, so bezieht sich das Aspektverhältnis auf die Breite eines Maximums, bei einem ringförmigen Strahlprofil also beispielsweise der Ringstärke. Bei einer Ausbildung mehrerer in lateraler Richtung beabstandeter Modifikationsvolumina bezieht sich das Aspektverhältnis auf die laterale Ausdehnung der einzelnen Modifikation. Bei einem in Ausbreitungsrichtung modulierten Strahlprofil (z.B. aufgrund von Interferenzen) ist das Aspektverhältnis auf die übergeordnete Gesamtlänge bezogen.

Ausgehend von einem Abstand d zwischen Strahlformungselement und Fokussierlinse (Nahfeldoptik), der insbesondere größer ist, als die Brennweite f_{N} der Nahfeldoptik, und einer NA der Nahfeldoptik gegenüber Luft > 0,15, kann das genutzte Winkelspektrum α des Strahlformungselements im Bereich tan(α) < f * NA/d < NA/2, und bevorzugt tan(α) > f * NA/(d * 4), liegen.

Soweit anwendbar, können alle einzelnen Merkmale, die in den Ausführungsbeispielen dargestellt sind, miteinander kombiniert und/oder ausgetauscht werden, ohne den Bereich der Erfindung zu verlassen.

### Bezugszeichenliste

- 1: Werkstück
- 2: Modifikationen
- 3, 3': Oberflächen
- 4: Durchgangslöcher
- 5: sanduhrförmiges Durchgangsloch
- 6: Sacklöcher
- 7: Stege
- 8: Gräben
- 9: Aussparungen
- 10: Kontur
- 11: Spalt
- 12: abgerundete Kante
- 21: Laserbearbeitungsanlage
- 23: Trägersystem
- 23A: Querträger
- 25: Werkstücklagerungseinheit
- 27: Auslegeranordnung
- 29: Rotationsachsen
- 31: optisches System

## Patentansprüche

1. Verfahren zum Bearbeiten eines Werkstücks (1), umfassend die Schritte:
- Einbringen einer Mehrzahl benachbarter Modifikationen (2) in das Material des Werkstücks (1) mittels Laserstrahlung,
- Ätzen des Materials des Werkstücks (1) in einem ersten Ätzvorgang mit einer ersten Selektivität, um überwiegend das durch die Laserstrahlung modifizierte Material zu entfernen, **gekennzeichnet durch**,
- nach Abschluss des ersten Ätzvorgangs, Ätzen des Materials des Werkstücks (1) in einem zweiten Ätzvorgang mit einer zweiten, zu der ersten Selektivität unterschiedlichen Selektivität, um die zwischen dem entfernten modifizierten Material übrig gebliebenen Stege zu entfernen.

2. Verfahren nach Anspruch 1, **dadurch gekennzeichnet, dass** sich der erste Ätzvorgang und der zweite Ätzvorgang durch die chemische Zusammensetzung, die Temperatur und/oder die Konzentration der Ätzlösungen und/oder durch die in einem Ultraschallbad eingebrachte Ultraschallleistung unterscheiden.

3. Verfahren nach Anspruch 1 oder 2, **dadurch gekennzeichnet, dass** sich die erste Selektivität und die zweite Selektivität um mindestens den Faktor 2, vorzugsweise um den Faktor 100, weiter vorzugsweise um den Faktor 10000 unterscheiden.

4. Verfahren nach einem der vorstehenden Ansprüche, **dadurch gekennzeichnet, dass** die erste Selektivität größer ist, als die zweite Selektivität.

5. Verfahren nach einem der vorstehenden Ansprüche, **dadurch gekennzeichnet, dass** zumindest einige der in das Material des Werkstücks (1) eingebrachten Modifikationen (2) unterschiedliche Längen aufweisen.

6. Verfahren nach Anspruch 5, **dadurch gekennzeichnet, dass** die Modifikationen (2) in Propagationsrichtung der Laserstrahlung unterschiedliche Längen aufweisen.

7. Verfahren nach einem der vorstehenden Ansprüche, **dadurch gekennzeichnet, dass** eine Mehrzahl von Modifikationen (2) entlang einer Kontur aneinander gereiht in das Material des Werkstücks (1) eingebracht werden.

8. Verfahren nach Anspruch 6, **dadurch gekennzeichnet, dass** jede Modifikation sich über die Dicke des Werkstücks (1) erstreckt, wobei die Kontur geschlossen ist und wobei das Ätzen in dem ersten und zweiten Ätzvorgang den von der Kontur umschlossenen Bereich des Materials entfernt.

9. Verfahren nach einem der Ansprüche 1 bis 3, **dadurch gekennzeichnet, dass** die erste Selektivität kleiner ist, als die zweite Selektivität.

10. Verfahren nach Anspruch 8, **dadurch gekennzeichnet, dass** durch den zweiten Ätzvorgang mit hoher Selektivität zwei Teile des Werkstücks (1) voneinander getrennt werden, wobei durch den ersten Ätzvorgang mit niedriger Selektivität eine Verrundung der beim zweiten Ätzvorgang entstehenden Trennkante bewirkt wird.

11. Verfahren nach einem der vorstehenden Ansprüche, **dadurch gekennzeichnet, dass** nach Abschluss des Ätzens des Materials im zweiten Ätzvorgang einer oder mehrere weitere Ätzvorgänge mit jeweils unterschiedlicher Selektivität erfolgen.

12. Verfahren nach einem der vorstehenden Ansprüche, **dadurch gekennzeichnet, dass** das Material des Werkstücks (1) für die Wellenlänge der Laserstrahlung transparent ist.

13. Verfahren nach einem der vorstehenden Ansprüche, **dadurch gekennzeichnet, dass** die Modifikationen (2) durch ultrakurze Laserpulse in das Material des Werkstücks (1) eingebracht werden.

## Claims

1. A method for machining a workpiece (1), comprising the steps of:
- introducing a plurality of adjacent modifications (2) into the material of the workpiece (1) by means of laser radiation,
- etching the material of the workpiece (1) in a first etching operation with a first selectivity in order to remove most of the material modified by the laser radiation, **characterized by**,
- after completion of the first etching operation, in a second etching operation with a second selectivity different from the first selectivity, etching the material of the workpiece (1) in order to remove the webs that remain behind between the removed modified material.

2. The method according to claim 1, **characterized in that** the first etching operation and the second etching operation differ by the chemical composition, the temperature and/or the concentration of the etching solutions and/or by the ultrasonic power introduced in an ultrasonic bath.

3. The method according to claim 1 or 2, **characterized in that** the first selectivity and the second selectivity differ by at least the factor of 2, preferably by the factor of 100, more preferably by the factor of 10,000.

4. The method according to any one of the preceding claims, **characterized in that** the first selectivity is greater than the second selectivity.

5. The method according to any one of the preceding claims, **characterized in that** at least some of the modifications (2) introduced into the material of the workpiece (1) have different lengths.

6. The method according to claim 5, **characterized in that** the modifications (2) have different lengths in the direction of propagation of the laser radiation.

7. The method according to any one of the preceding claims, **characterized in that** a plurality of modifications (2) are introduced into the material of the workpiece (1) lined up together along a contour.

8. The method according to claim 6, **characterized in that** each modification extends over the thickness of the workpiece (1), wherein the contour is closed and wherein the etching in the first and second etching operations removes the region of the material enclosed by the contour.

9. The method according to claims 1 to 3, **characterized in that** the first selectivity is less than the second selectivity.

10. The method according to claim 8, **characterized in that** two parts of the workpiece (1) are separated from one another by the second etching operation with high selectivity, wherein a rounding of the separating edge created during the second etching operation is brought about by the first etching operation with low selectivity.

11. The method according to any one of the preceding claims, **characterized in that** after completion of the etching of the material, one or more further etching operations take place in the second etching operation, each with a different selectivity.

12. The method according to any one of the preceding claims, **characterized in that** the material of the workpiece (1) is transparent to the wavelength of the laser radiation.

13. The method according to any one of the preceding claims, **characterized in that** the modifications (2) are introduced into the material of the workpiece (1) by ultrashort laser pulses.

## Revendications

1. Procédé d'usinage d'une pièce (1), comprenant les étapes :
- l'introduction d'une pluralité de modifications (2) adjacentes dans le matériau de la pièce (1) au moyen d'un rayonnement laser,
- l'attaque chimique du matériau de la pièce (1) lors d'une première opération d'attaque chimique présentant une première sélectivité, afin d'éliminer principalement le matériau modifié par le rayonnement laser, **caractérisé en ce que**,
- après l'achèvement de la première opération d'attaque chimique, l'attaque chimique du matériau de la pièce (1) lors d'une deuxième opération d'attaque chimique présentant une deuxième sélectivité, différente de la première sélectivité, afin d'éliminer les ponts restants laissés entre le matériau modifié éliminé.

2. Procédé selon la revendication 1, **caractérisé en ce que** la première opération d'attaque chimique et la deuxième opération d'attaque chimique diffèrent par la composition chimique, la température et/ou la concentration des solutions d'attaque chimique et/ou par la puissance ultrasonore introduite dans un bain à ultrasons.

3. Procédé selon la revendication 1 ou 2, **caractérisé en ce que** la première sélectivité et la deuxième sélectivité diffèrent d'au moins le facteur 2, de préférence le facteur 100, et plus préférentiellement le facteur 10000.

4. Procédé selon l'une quelconque des revendications précédentes, **caractérisé en ce que** la première sélectivité est supérieure à la deuxième sélectivité.

5. Procédé selon l'une quelconque des revendications précédentes, **caractérisé en ce qu'**au moins certaines des modifications (2) introduites dans le matériau de la pièce (1) présentent des longueurs différentes.

6. Procédé selon la revendication 5, **caractérisé en ce que** les modifications (2) présentent, dans la direction de propagation du rayonnement laser, des longueurs différentes.

7. Procédé selon l'une quelconque des revendications précédentes, **caractérisé en ce qu'**une pluralité de modifications (2) sont introduites dans le matériau de la pièce (1) le long d'un contour, alignées bout à bout.

8. Procédé selon la revendication 6, **caractérisé en ce que** chaque modification s'étend sur toute l'épaisseur de la pièce (1), dans lequel le contour est fermé et dans lequel l'attaque chimique, lors de la première et de la deuxième opération d'attaque chimique, élimine la zone du matériau délimitée par le contour.

9. Procédé selon l'une quelconque des revendications 1 à 3, **caractérisé en ce que** la première sélectivité est inférieure à la deuxième sélectivité.

10. Procédé selon la revendication 8, **caractérisé en ce que**, lors de la deuxième opération d'attaque chimique à haute sélectivité, deux parties de la pièce (1) sont séparées l'une de l'autre, dans lequel, lors de la première opération d'attaque chimique à faible sélectivité, un arrondi est formé sur l'arête de séparation générée lors de la deuxième opération d'attaque chimique.

11. Procédé selon l'une quelconque des revendications précédentes, **caractérisé en ce qu'**après l'achèvement de l'attaque chimique du matériau lors de la deuxième opération d'attaque chimique, une ou plusieurs autres opérations d'attaque chimique supplémentaires sont effectuées, chacune présentant une sélectivité différente.

12. Procédé selon l'une quelconque des revendications précédentes, **caractérisé en ce que** le matériau de la pièce (1) est transparent pour la longueur d'onde du rayonnement laser.

13. Procédé selon l'une quelconque des revendications précédentes, **caractérisé en ce que** les modifications (2) sont introduites dans le matériau de la pièce (1) par des impulsions laser ultracourtes.
